# EUROPEAN PATENT SPECIFICATION

(11) **EP 2 378 751 B1**
(45) Date of publication and mention of the grant of the patent: **08.08.2018**
(21) Application number: 11002475.9
(22) Date of filing: 24.03.2011
(51) Int. Cl.: H04M 1/725

(54) **Selection of an e-mail receiving mode by a mobile terminal**
Auswahl eines E-Mail-Empfang-Modus von einem mobilen Endgerät
Sélection d'un mode réception de courrier électronique par un terminal mobile

(30) Priority: 15.04.2010 KR 20100034549
(43) Date of publication of application: 19.10.2011
(73) Proprietor: LG Electronics Inc., Seoul 150-721 (KR)
(72) Inventor: Kim, Taeyong, Seoul 153-801 (KR)
(74) Representative: Frenkel, Matthias Alexander

(56) References cited:
- JP-A- 2002 197 033
- JP-A- 2007 221 448
- US-A1- 2005 193 070
- US-A1- 2008 242 370

## Description

### BACKGROUND

### Field of the Invention

This document relates to a mobile terminal and an e-mail service providing method thereof.

### Related Art

Terminals can be divided into mobile terminals and stationary terminals. The mobile terminals can be classified into handheld terminals and vehicle mount terminals according to whether users can personally carry the terminals.

There is a recent trend of providing an e-mail service through mobile terminals, and thus improvement of structural parts and/or software parts of the mobile terminals is considered.

Patent application US 2005/0193070 A1 discloses a method for providing a portion of an electronic mail message based upon a transfer rate, a message size, and a file format. The method includes determining whether it is desirable to provide less than all of an electronic mail message and determining a format associated with the electronic mail message in response to determining that it is desirable to provide less than all of the electronic mail message. The method also includes selecting a portion of the electronic mail message using the determined format and providing the selected portion of the electronic mail message.

Patent application JP 2007-221448 A discloses a portable mobile terminal which has a mail acquisition mode setting means and which receives e-mail in a manual acquisition mode or an automatic acquisition mode. In the manual acquisition mode, the portable mobile terminal once receives only a header part of the e-mail and, if needed, a user later gives an instruction to acquire the text. In the automatic acquisition mode, the portable mobile terminal simultaneously acquires the header part and the text if the residual amount of the battery is equal to or more than a threshold, and shifts to the manual acquisition mode to first receive only the header part if the residual amount of the battery is less than the threshold.

### SUMMARY

According to aspects of the present invention, a method of receiving e-mail by a mobile terminal and a corresponding mobile terminal are provided according to the independent claims. Preferred embodiments are recited in the dependent claims.
The embodiments and/or examples of the following description which are not covered by the appended claims are considered as not being part of the present invention.

Examples of the present disclosure relate to a mobile terminal and an e-mail service providing method of the mobile terminal for selecting e-mail receiving mode.

According to one example, a mobile terminal includes: a wireless communication unit configured to transmit and receive an e-mail; and a controller configured to control the wireless communication unit to receive the e-mail in either a
split receiving mode or an entire receiving mode based on at least one of an e-mail receiving environment related to the e-mail and an e-mail utilization pattern of a user, wherein the split receiving mode receives parts of the e-mail from a sender and the entire receiving mode receives the entire e-mail from the sender.

According to another example, a mobile terminal includes: a wireless communication unit configured to transmit and receive an e-mail; and a controller configured to obtain an e-mail receiving pattern of the wireless communication unit; and control the wireless communication unit to switch between a split receiving mode and an entire receiving mode for receiving the e-mail, wherein the split receiving mode receives parts of the e-mail from a sender and the entire receiving mode receives the entire e-mail from the sender.

According to yet another example, a method of receiving e-mail in a mobile terminal includes: obtaining an e-mail receiving pattern including an e-mail receiving environment of the mobile terminal or an e-mail utilization pattern of a user; receiving an e-mail in either a split receiving mode or an entire receiving mode based on the e-mail receiving pattern, wherein the split receiving mode receives parts of the e-mail from a sender and the entire receiving mode receives the entire e-mail from the sender.

### BRIEF DESCRIPTION OF THE DRAWINGS

The accompanying drawings, which are included to provide a further understanding of described embodiments of the present invention and are incorporated in and constitute a part of this specification, illustrate embodiments of the present invention and together with the description serve to explain aspects and features of the present invention.
FIG. 1 is a block diagram illustrating a configuration of a mobile terminal according to embodiments of the present invention;
FIG. 2 illustrates an e-mail data structure for explaining a receiving mode when e-mail is initially received;
FIG. 3 illustrates exemplary consumed current according to the e-mail receiving mode of a mobile terminal;
FIGS. 4 is a flowchart illustrating an e-mail receiving method of the mobile terminal according to an embodiment of the present invention; and
FIGS. 5, 6 and 7 illustrate implementations of determining an e-mail receiving mode using an e-mail receiving pattern.

### DETAILED DESCRIPTION

Embodiments of the present invention will now be described more fully with reference to the accompanying drawings, in which certain embodiments of the invention are illustrated. The invention may, however, be embodied in many different forms and should not be construed as being limited to the embodiments set forth herein; rather, these embodiments are described and/or illustrated so that this disclosure will be more thorough and complete, and will more fully convey the aspects of the invention to those skilled in the art.

Hereinafter, a mobile terminal relating to the present invention will be described below in more detail with reference to the accompanying drawings. In the following description, suffixes "module" and "unit" are given to components of the mobile terminal in consideration of only facilitation of description and do not have meanings or functions discriminated from each other.

The mobile terminal described in the specification can include a cellular phone, a smart phone, a laptop computer, a digital broadcasting terminal, personal digital assistants (PDA), a portable multimedia player (PMP), a navigation system and so on.

However, those skilled in the art will easily understand that configurations according to embodiments of the present invention can also be applied to stationary terminals such as digital TV and desktop computers except a case where the configurations can be applied to only mobile terminals.

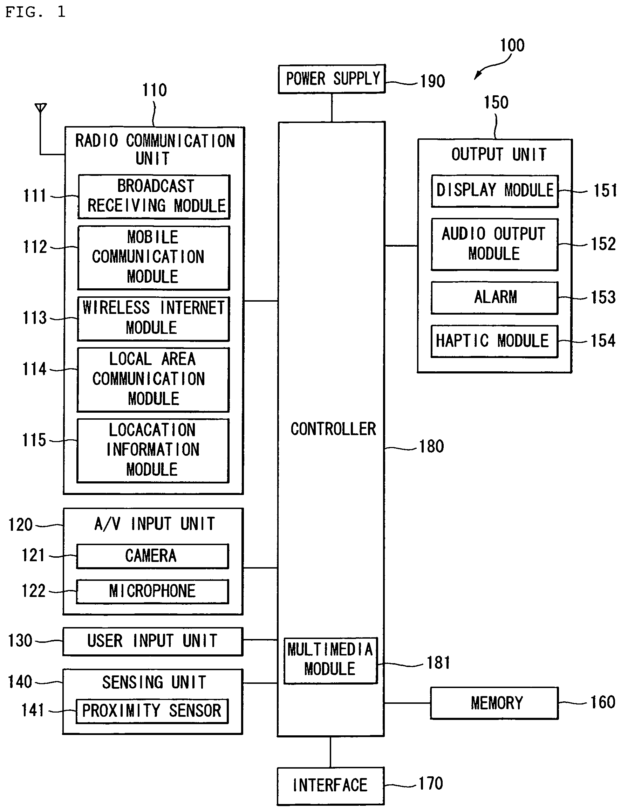

FIG. 1 is a block diagram of a mobile terminal 100 according to an example embodiment. Other embodiments, configurations and arrangements may also be provided. As shown, a mobile terminal 100 may include a radio communication unit 110, an audio/video (A/V) input unit 120, a user input unit 130, a sensing unit 140, an output unit 150, a memory 160, an interface 170, a controller 180 and a power supply 190. The components shown in FIG. 1 are not essential parts and the number of components included in the mobile terminal can be varied.

The components of the mobile terminal will now be described.

The radio communication unit 110 can include at least one module that enables radio communication between the mobile terminal 100 and a radio communication system or between the mobile terminal 100 and a network in which the mobile terminal 100 is located. For example, the radio communication unit 110 can include a broadcasting receiving module 111, a mobile communication module 112, a wireless Internet module 113, a local area communication module 114 and a position information module 115.

The broadcasting receiving module 111 receives broadcasting signals and/or broadcasting related information from an external broadcasting management server through a broadcasting channel.

The broadcasting channel can include a satellite channel and a terrestrial channel. The broadcasting management server can be a server that generates and transmits broadcasting signals and/or broadcasting related information or a server that receives previously created broadcasting signals and/or broadcasting related information and transmits the broadcasting signals and/or broadcasting related information to a terminal. The broadcasting signals can include not only TV broadcasting signals, radio broadcasting signals and data broadcasting signals but also signals in the form of combination of a TV broadcasting signal and a radio broadcasting signal.

The broadcasting related information can be information on a broadcasting channel, a broadcasting program or a broadcasting service provider. The broadcasting related information can be provided even through a mobile communication network. In this case, the broadcasting related information can be received by the mobile communication module 112.

The broadcasting related information can exist in various forms. For example, the broadcasting related information can exist in the form of electronic program guide (EPG) of digital multimedia broadcasting (DMB) or in the form of electronic service guide (ESG) of digital video broadcast-handheld (DVB-H).

The broadcasting receiving module 111 receives broadcasting signals using various broadcasting systems. Particularly, the broadcasting receiving module 111 can receive digital broadcasting signals using digital broadcasting systems such as digital multimedia broadcasting-terrestrial (DMB-T), digital multimedia broadcasting-satellite (DMB-S), media forward link only (MediaFLO), DVB-H and integrated services digital broadcast-terrestrial (ISDB-T) systems. The broadcasting receiving module 111 can be constructed to be suited to broadcasting systems providing broadcasting signals other than the above-described digital broadcasting systems.

The broadcasting signals and/or broadcasting related information received through the broadcasting receiving module 111 can be stored in the memory 160.

The mobile communication module 112 transmits/receives a radio signal to/from at least one of a base station, an external terminal and a server on a mobile communication network. The radio signal can include a voice call signal, a video telephony call signal or data in various forms according to transmission and receiving of text/multimedia messages.

The wireless Internet module 113 means a module for wireless Internet access and can be included in the mobile terminal 100 or externally attached to the mobile terminal 100. Wireless LAN (WLAN) (Wi-Fi), wireless broadband (Wibro), world interoperability for microwave access (Wimax), high speed downlink packet access (HSDPA) and so on can be used as a wireless Internet technique.

The local area communication module 114 means a module for local area communication. Bluetooth, radio frequency identification (RFID), infrared data association (IrDA), ultra wideband (UWB) and ZigBee can be used as a local area communication technique.

The position information module 115 confirms or obtains the position of the mobile terminal. A global positioning system (GPS) module is a representative example of the position information module 115. According to the current technology, the GPS module 115 can calculate information on distances between one point (object) and at least three satellites and information on the time when the distance information is measured and apply trigonometry to the obtained distance information to obtain three-dimensional position information on the point (object) according to latitude, longitude and altitude at a predetermined time. Furthermore, a method of calculating position and time information using three satellites and correcting the calculated position and time information using another satellite is also used. In addition, the GPS module 115 continuously calculates the current position in real time and calculates velocity information using the position information.

Referring to FIG. 1, the A/V input unit 120 is used to input an audio signal or a video signal and can include a camera 121 and a microphone 122. The camera 121 processes image frames of still images or moving images obtained by an image sensor in a video telephony mode or a photographing mode. The processed image frames can be displayed on a display unit 151.

The image frames processed by the camera 121 can be stored in the memory 160 or transmitted to an external device through the radio communication unit 110. The mobile terminal 100 can include at least two cameras according to constitution of the terminal.

The microphone 122 receives an external audio signal in a call mode, a recording mode or a speed recognition mode and processes the received audio signal into electric audio data. The audio data can be converted into a form that can be transmitted to a mobile communication base station through the mobile communication module 112 and output in the call mode. The microphone 122 can employ various noise removal algorithms for removing noise generated when the external audio signal is received.

The user input unit 130 receives input data for controlling the operation of the terminal from a user. The user input unit 130 can include a keypad, a dome switch, a touch pad (constant voltage/capacitance), jog wheel, jog switch and so on.

The sensing unit 140 senses the current state of the mobile terminal 100, such as open/close state of the mobile terminal 100, the position of the mobile terminal 100, whether a user touches the mobile terminal 100, the direction of the mobile terminal 100 and acceleration/deceleration of the mobile terminal 100 and generates a sensing signal for controlling the operation of the mobile terminal 100. For example, the sensing unit 140 can sense whether a slide phone is opened or closed when the mobile terminal 100 is the slide phone. Furthermore, the sensing unit 140 can sense whether the power supply 190 supplies power and whether the interface 170 is connected to an external device. The sensing unit 140 can include a proximity sensor.

The output unit 150 generates visual, auditory or tactile output and can include the display unit 151, an audio output module 152, an alarm 153 and a haptic module 154.

The display unit 151 displays information processed by the mobile terminal 100. For example, the display unit 151 displays UI or graphic user interface (GUI) related to a telephone call when the mobile terminal is in the call mode. The display unit 151 displays a captured or/and received image, UI or GUI when the mobile terminal 100 is in the video telephony mode or the photographing mode.

The display unit 151 can include at least one of a liquid crystal display, a thin film transistor liquid crystal display, an organic light-emitting diode display, a flexible display and a three-dimensional display.

Some of these displays can be of a transparent type or a light transmission type. This can be referred to as a transparent display. The transparent display includes a transparent liquid crystal display. The rear structure of the display unit 151 can also be of the light transmission type. According to this structure, a user can see an object located behind the body of the mobile terminal 100 through an area of the body of the mobile terminal 100, which is occupied by the display unit 151.

The mobile terminal 100 can include at least two display units 151 according to constitution of the terminal. For example, the mobile terminal 100 can include a plurality of displays that are arranged on a single face at a predetermined distance or integrated. Otherwise, the plurality of displays can be arranged on different sides.

In the case where the display unit 151 and a sensor sensing touch (referred to as a touch sensor hereinafter) form a layered structure, which is referred to as a touch screen hereinafter, the display unit 151 can be used as an input device in addition to an output device. The touch sensor can be in the form of a touch film, a touch sheet and a touch pad, for example.

The touch sensor can be constructed such that it converts a variation in pressure applied to a specific portion of the display unit 151 or a variation in capacitance generated at a specific portion of the display unit 151 into an electric input signal. The touch sensor can be constructed such that it can sense pressure of touch as well as the position and area of touch.

When touch input is applied to the touch sensor, a signal corresponding to the touch input is transmitted to a touch controller. The touch controller processes the signal and transmits data corresponding to the processed signal to the controller 180. Accordingly, the controller 180 can detect a touched portion of the display 151.

Referring to FIG. 1, the proximity sensor 141 can be located in an internal region of the mobile terminal, surrounded by the touch screen, or near the touch screen. The proximity sensor senses an object approaching a predetermined sensing face or an object located near the proximity sensor using electromagnetic force or infrared rays without having mechanical contact. The proximity sensor has lifetime longer than that of a contact sensor and has wide application.

The proximity sensor includes a transmission type photo-electric sensor, a direct reflection type photo-electric sensor, a mirror reflection type photo-electric sensor, a high-frequency oscillating proximity sensor, a capacitive proximity sensor, a magnetic proximity sensor, an infrared proximity sensor, etc.

A capacitive touch screen is constructed such that proximity of a pointer is detected through a variation in an electric field according to the proximity of the pointer. In this case, the touch screen (touch sensor) can be classified as a proximity sensor.

For convenience of explanation, an action of approaching the pointer to the touch screen while the pointer it not being in contact with the touch screen such that location of the pointer on the touch screen is recognized is referred to as "proximity touch" and an action of bring the pointer into contact with the touch screen is referred to as "contact touch" in the following description. A proximity touch point of the pointer on the touch screen means a point of the touch screen to which the pointer corresponds perpendicularly to the touch screen when the pointer proximity-touches the touch screen.

The proximity sensor senses proximity touch and a proximity touch pattern (for example, a proximity touch distance, a proximity touch direction, a proximity touch velocity, a proximity touch time, a proximity touch position, a proximity touch moving state, etc.). Information corresponding to the sensed proximity touch action and proximity touch pattern can be displayed on the touch screen.

The audio output module 152 can output audio data received from the radio communication unit 110 or stored in the memory 160 in a call signal receiving mode, a telephone call mode or a recording mode, a speech recognition mode and a broadcasting receiving mode. The audio output module 152 outputs audio signals related to functions (for example, a call signal incoming tone, a message incoming tone, etc.) performed in the mobile terminal 100. The audio output module 152 can include a receiver, a speaker, a buzzer, etc.

The alarm 153 outputs a signal for indicating generation of an event of the mobile terminal 100. Examples of events generated in the mobile terminal include receiving of a call signal, receiving of a message, input of a key signal, input of touch, etc. The alarm 153 can output signals in forms different from video signals or audio signals, for example, a signal for indicating generation of an event through vibration. The video signals or the audio signals can be also output through the display unit 151 or the audio output module 152.

The haptic module 154 generates various haptic effects that the user can feel. A representative example of the haptic effects is vibration. The intensity and pattern of vibration generated by the haptic module 154 can be controlled. For example, different vibrations can be combined and output or sequentially output.

The haptic module 154 can generate a variety of haptic effects including an effect of stimulus according to arrangement of pins vertically moving for a contact skin face, an effect of stimulus according to jet force or sucking force of air through a jet hole or a sucking hole, an effect of stimulus rubbing the skin, an effect of stimulus according to contact of an electrode, an effect of stimulus using electrostatic force and an effect according to reproduction of cold and warmth using an element capable of absorbing or radiating heat in addition to vibrations.

The haptic module 154 can not only transmit haptic effects through direct contact but also allow the user to feel haptic effects through kinesthetic sense of his fingers or arms. The mobile terminal 100 can include at least two haptic modules 154 according to constitution of the mobile terminal.

The memory 160 can store a program for the operation of the controller 180 and temporarily store input/output data (for example, phone book, messages, still images, moving images, etc.). The memory 160 can store data about vibrations and sounds in various patterns, which are output from when a touch input is applied to the touch screen.

The memory 160 can include at least one of a flash memory, a hard disk type memory, a multimedia card micro type memory, a card type memory (for example, SD or XD memory), a random access memory (RAM), a static RAM (SRAM), a read-only memory (ROM), an electrically erasable programmable ROM (EEPROM), a programmable ROM (PROM) magnetic memory, a magnetic disk and an optical disk. The mobile terminal 100 can operate in relation to a web storage performing the storing function of the memory 160 on the Internet.

The interface 170 serves as a path to all external devices connected to the mobile terminal 100. The interface 170 receives data from the external devices or power and transmits the data or power to the internal components of the mobile terminal 100 or transmits data of the mobile terminal 100 to the external devices. The interface 170 can include a wired/wireless headset port, an external charger port, a wired/wireless data port, a memory card port, a port for connecting a device having a user identification module, an audio I/O port, a video I/O port, an earphone port, etc., for example.

An identification module is a chip that stores information for authenticating the authority to use the mobile terminal 100 and can include a user identify module (UIM), a subscriber identify module (SIM) and a universal subscriber identify module (USIM). A device (referred to as an identification device hereinafter) including the identification module can be manufactured in the form of a smart card. Accordingly, the identification device can be connected to the mobile terminal 100 through a port.

The interface 170 can serve as a path through which power from an external cradle is provided to the mobile terminal 100 when the mobile terminal 100 is connected to the external cradle or a path through which various command signals inputted by the user through the cradle to the mobile terminal 100. The various command signals or power input from the cradle can be used as a signal for confirming whether the mobile terminal 100 is correctly set in the cradle.

The controller 180 controls the overall operation of the mobile terminal. For example, the controller 180 performs control and processing for voice communication, data communication and video telephony. The controller 180 can include a multimedia module 181 for playing multimedia. The multimedia module 181 can be included in the controller 180 or separated from the controller 180.

The controller 180 can perform a pattern recognition process capable of recognizing handwriting input or picture-drawing input applied to the touch screen as characters or images.

The power supply 190 receives external power and internal power and provides power required for the operations of the components of the mobile terminal under the control of the controller 180.

Various embodiments of the present invention can be implemented in a computer or similar device readable recording medium using software, hardware or a combination thereof, for example.

According to hardware implementation, the embodiments of the present invention can be implemented using at least one of application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, electrical units for executing functions. In some cases, the embodiments can be implemented by the controller 180.

According to software implementation, embodiments such as procedures or functions can be implemented with a separate software module executing at least one function or operation. Software codes can be implemented according to a software application written in an appropriate software language. Furthermore, the software codes can be stored in the memory 160 and executed by the controller 180.

Embodiments described in this document may be implemented in the mobile terminal 100 explained with reference to FIG. 1.

An e-mail receiving method of the mobile terminal 100 and an operation of the mobile terminal 100 for implementing the e-mail receiving method will now be explained. Particularly, a method of receiving e-mail according to e-mail push and an operation of the mobile terminal 100 for implementing the method are described.

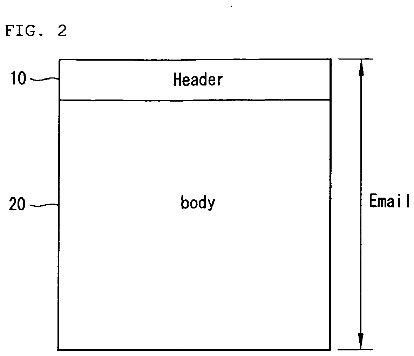

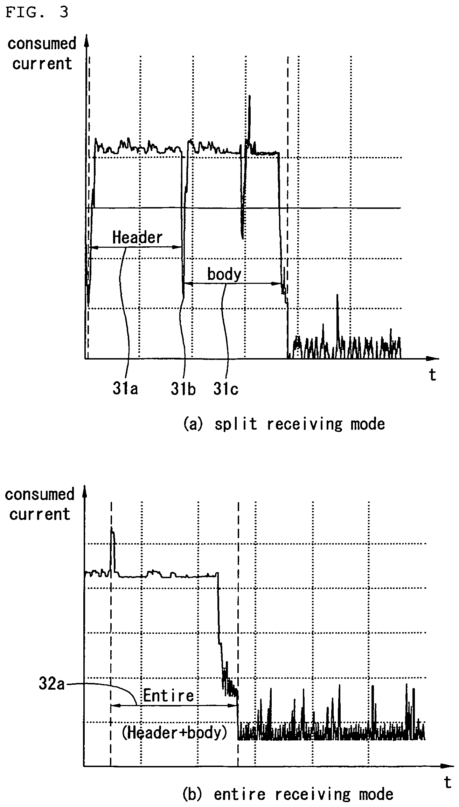

FIG. 2 illustrates an e-mail data structure for explaining a receiving mode when e-mail is initially received and FIG. 3 illustrates exemplary consumed current according to the e-mail receiving mode of the mobile terminal 100.

Referring to FIG. 2, an e-mail includes a header 10 and a body 20. The header 10 includes the title, sender identification information, etc. of the e-mail and the body 20 includes the text of the e-mail created by a sender.

E-mail receiving modes of the mobile terminal 100 is divided into a split receiving mode for splitting and receiving e-mail and an entire receiving mode for receiving the entire e-mail. In the split receiving mode, the mobile terminal 100 receives parts of e-mails, for example, only the header 10, and generates a list of received e-mails using the received header 10. Then, when a user requests the mobile terminal 100 to receive the entire e-mail through the user input unit 130, the mobile terminal 100 receives the entire e-mail. In the entire receiving mode, the mobile terminal 100 receives the entire e-mail from the beginning.

Referring to FIG. 3, when the mobile terminal 100 operates in the split receiving mode (a), the mobile terminal 100 activates an e-mail receiving related function of the wireless communication unit 110 to receive the header 10 of the e-mail transmitted to the mobile terminal 100 (31a). Then, the mobile terminal 100 inactivates the e-mail receiving related function of the wireless communication unit 110 until the user requests the mobile terminal 100 to receive the entire e-mail (31b). When the user requests the mobile terminal 100 to receive the entire e-mail, the mobile terminal 100 activates the e-mail receiving related function of the wireless communication unit 110 again to receive the body 20 of the e-mail.

When the mobile terminal 100 operates in the entire receiving mode (b), the mobile terminal 100 activates the e-mail receiving related function of the wireless communication unit 110 only once to receive the entire e-mail 10 and 20 transmitted to the mobile terminal 100 (32a).

Referring to FIG. 3 (a) and (b), the current consumed when the mobile terminal 100 operates in the entire receiving mode is less than the current consumed when the mobile terminal 100 operates in the split receiving mode. This is because that the operation of activating the e-mail receiving related function of the wireless communication unit 110 increases the consumed current of the mobile terminal 100 since the mobile terminal 100 activates the e-mail receiving related function of the wireless communication unit 110 twice when operating in the split receiving mode. The wireless communication unit 110 consumes more current for the operation of activating the e-mail receiving related function than the operation of receiving e-mail.

Furthermore, in the split receiving mode, the mobile terminal 100 displays a list of received e-mails, receives an entire e-mail receiving request through the user input unit 130 and activates the display module 151 while receiving the body 20 of the e-mail. Accordingly, the mobile terminal 100 additionally consumes current according to the activation of the display module 151. When the mobile terminal 100 operates in the entire receiving mode, the mobile terminal 100 receives all of e-mails while the display module 151 is being inactivated and activates the display module 151 only when displaying a list of the received e-mails on the display module 151. Accordingly, the current consumed for the activation of the display module 151 in the entire receiving mode is less than the current consumed for the activation of the display module 151 in the split receiving mode.

Although the current consumed when the mobile terminal 100 operates in the entire receiving mode is less than the current consumed when the mobile terminal 100 operates in the split receiving mode, to operate the mobile terminal 100 in the split receiving mode may be more efficient due to various factors.

For example, the mobile terminal 100 operating in the entire receiving mode receives the entire data of every e-mail transmitted thereto and then generates an e-mail list. Accordingly, when an e-mail receiving rate is low due to an e-mail receiving environment including network characteristic, platform specifications of the mobile terminal 100, etc., a time required for the mobile terminal 100 to generate the e-mail list increases to cause user's inconvenience.

Furthermore, if the ratio of e-mails having bodies displayed at the user's request to received e-mails is low, to operate the mobile terminal 100 in the entire receiving mode for every e-mail may be inefficient.

As described above, it is required to consider various factors including an e-mail receiving environment, the platform characteristic of the mobile terminal 100 and user characteristic in addition to the consumed current to determine the e-mail receiving mode of the mobile terminal 100.

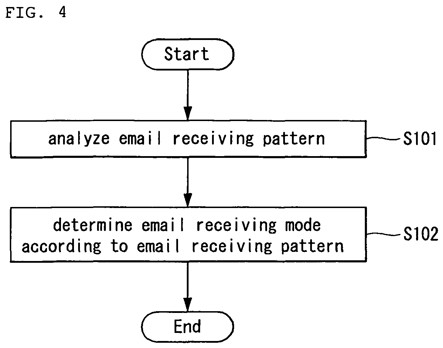

FIG. 4 is a flowchart illustrating an e-mail receiving method of the mobile terminal 100 according to an embodiment of the present invention.

Referring to FIGS. 1 and 4, the controller 180 analyzes an e-mail receiving pattern of the wireless communication unit 110 in operation S101. Here, the initial e-mail receiving mode of the mobile terminal 100 may be the entire receiving mode or the split receiving mode while the mobile terminal 100 initially operates to analyze the e-mail receiving pattern.

The e-mail receiving pattern may include the e-mail receiving environment of the mobile terminal 100, an e-mail utilization pattern of the user, whether the e-mail is received from a sender registered in the mobile termibal 100, etc. The e-mail receiving environment of the mobile terminal 100 is determined by the receiving environment and platform characteristic of the mobile terminal 100 and may include an e-mail receiving capability, a power consumption, etc. The e-mail receiving capability may include an e-mail receiving rate that represents a data size of e-mail received per unit time through the wireless communication unit 110. The power consumption may include a consumed current variation according to e-mail size and the consumed current variation represents a variation in the consumed current, that is, peak current, of the mobile terminal 100 according to the size of e-mail transmitted/received through the wireless communication unit 110. The e-mail utilization pattern may include a ratio of e-mails that are confirmed by the user to e-mails received via the wireless communication unit 110, that is, the ratio of e-mails requested by the user to display bodies thereof to all the received e-mails. Also, the e-mail utilization pattern may include a ratio of emails that are received from a registered sender in the mobile terminal to e-mails received via the wireless communication unit 110.

The controller 180 analyzes the e-mail receiving pattern only until the mobile terminal 100 initially operates to satisfy a predetermined condition. That is, the controller 180 analyzes the e-mail receiving pattern until specific results are obtained for parameters included in the e-mail receiving pattern.

For example, when the e-mail receiving rate corresponds to a parameter, the controller 180 can analyze the e-mail receiving rate until more than a predetermined number of e-mails are received or an e-mail having more than a predetermined size is received.

When a consumed current variation according to e-mail size corresponds to a parameter, the controller 180 can analyze the consumed current variation until an e-mail having a size that causes a variation in the consumed current of the mobile terminal 100 is received. Almost the same current is consumed to transmit/receive e-mails having sizes less than a predetermined size irrespective of e-mail size in terms of the characteristic of the wireless communication unit 110. Accordingly, the controller 180 continuously analyzes the consumed current variation according to e-mail size until a threshold value at which the current consumed to transmit/receive e-mails begins to vary according to e-mail size is obtained.

If the user's e-mail utilization pattern corresponds to a parameter included in the e-mail receiving pattern, the controller 180 continuously analyzes the user's e-mail utilization pattern until the number of times of receiving e-mail exceeds a predetermined number of times.

Though the controller 180 analyzes the e-mail receiving pattern only until the predetermined condition is satisfied in the current embodiment of the invention, the present invention is not limited thereto. The e-mail receiving pattern may be continuously analyzed while the mobile terminal 100 operates. In this case, the mobile terminal 100 can continuously apply parameters variable with time, such as the e-mail utilization pattern of the user, etc., to the analysis of the e-mail receiving pattern.

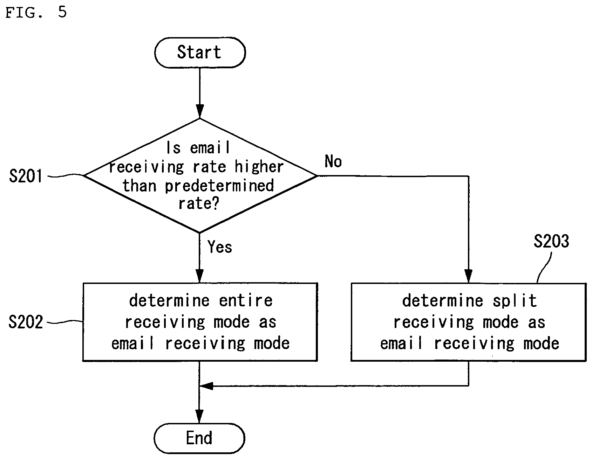

Referring back to FIG. 4, after the analysis of the e-mail receiving pattern, the controller 180 determines the entire receiving mode or the split receiving mode as the e-mail receiving mode according to the e-mail receiving pattern in operation S102. The method of determining the e-mail receiving mode of the mobile terminal 100 by analyzing the e-mail receiving pattern will be explained below with reference to FIGS. 5, 6 and 7.

When the e-mail receiving mode is determined, the controller 180 operates in the determined e-mail receiving mode to receive e-mail. For example, when the e-mail receiving mode corresponds to the split receiving mode, the mobile terminal 100 receives parts of an e-mail first and then receives the entire e-mail only when the user requests the mobile terminal 100 to receive the entire e-mail. When the e-mail receiving mode corresponds to the entire receiving mode, the mobile terminal 100 receives the entire e-mail at a time.

FIGS. 5, 6 and 7 illustrate implementations of determining the e-mail receiving mode using the respective parameters of the e-mail receiving pattern.

Referring to FIG. 5, the controller 180 compares the e-mail receiving rate among the parameters included in the e-mail receiving pattern with a predetermined rate in operation S201. When the e-mail receiving rate of the mobile terminal 100 is higher than the predetermined rate, the e-mail receiving mode of the mobile terminal 100 is determined as the entire receiving mode in operation S202. When the e-mail receiving rate of the mobile terminal 100 is lower than the predetermined rate, the e-mail receiving mode of the mobile terminal 100 is determined as the split receiving mode in operation S203.

When the mobile terminal 100 is requested by the user to provide the e-mail service, the mobile terminal 100 displays an e-mail list composed of only brief information included in the headers of received e-mails on the screen, in general. When a specific e-mail is selected from the displayed e-mail list, the mobile terminal 100 displays detailed information including the body of the selected e-mail on the screen. Here, if the e-mail receiving rate is low, a time required to receive the entire e-mails and generate the e-mail list is much longer than a time required to generate the e-mail list using only the headers of received e-mails. Accordingly, it is more efficient that the mobile terminal 100 operates in the split receiving mode in this case.

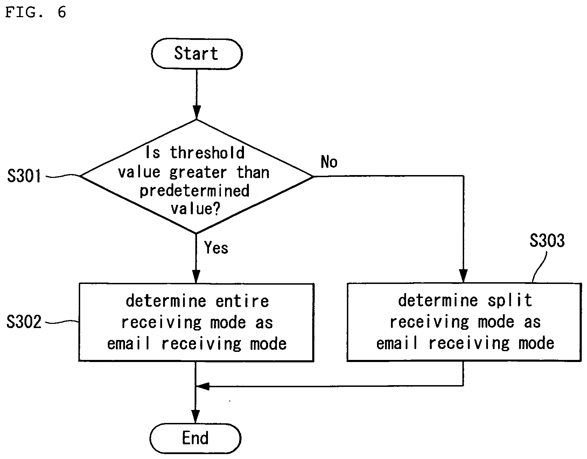

Referring to FIG. 6, the controller 180 analyzes a consumed current variation according to e-mail size, which corresponds to one of the parameters included in the e-mail receiving pattern, to obtain a threshold value and compares the threshold value with a predetermined value in operation S301. Here, the predetermined value compared to the threshold value can use a statistical value that represents an average e-mail size. When the threshold value is greater than the predetermined value, the controller 180 determines the e-mail receiving mode of the mobile terminal 100 as the entire receiving mode in operation S302. When the threshold value is smaller than the predetermined value, the controller 180 determines the e-mail receiving mode of the mobile terminal 100 as the split receiving mode in operation S303.

The fact that the threshold value for discriminating a state that the consumed current is constant irrespective of e-mail size from a state that the consumed current varies with e-mail size is greater than the average e-mail size means that the mobile terminal 100 consumes almost the same current in both a case that the mobile terminal 100 receives the entire e-mail and a case that the mobile terminal 100 receives parts of the e-mail. Accordingly, the consumed current does not remarkably increase even when the mobile terminal 100 operates in the entire receiving mode in this case.

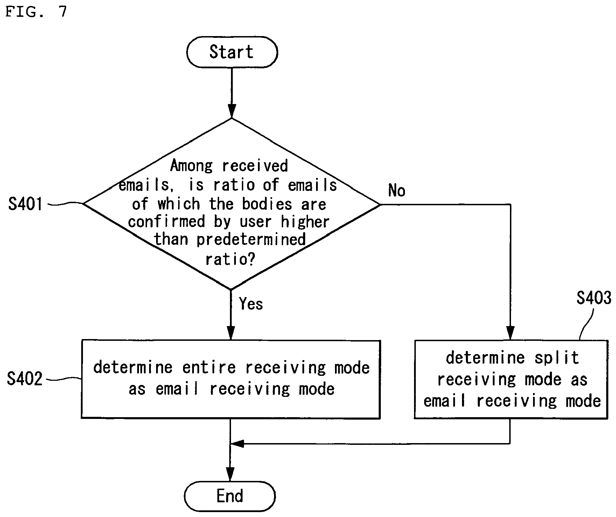

Referring to FIG. 7, the controller 180 analyzes the user's e-mail utilization pattern among the parameters included in the e-mail receiving pattern to decide whether the ratio of e-mails of which the bodies are confirmed by a user among received e-mails exceeds a predetermined value in operation S401. When the ratio exceeds the predetermined value, the controller 180 determines the e-mail receiving mode of the mobile terminal 100 as the entire receiving mode in operation S402. When the ratio is less than the predetermined value, the controller 180 determines the e-mail receiving mode of the mobile terminal 100 as the split receiving mode in operation S403.

When the user confirms the bodies of most of received e-mails, the mobile terminal 100 may operate in the entire receiving mode to minimize a delay time from when the user selects a specific e-mail from the e-mail list to when the user receives the specific e-mail to thereby improve user's convenience.

Referring back to FIG. 4, the controller 180 finally determines the e-mail receiving mode as the entire receiving mode when the e-mail receiving pattern satisfies all the conditions explained with reference to FIGS. 5, 6 and 7 in operation S102. However, the present invention is not limited thereto and the e-mail receiving mode can be determined as the entire receiving mode even when at least one of the conditions is satisfied.

Although the e-mail is composed of the header 10 and the body 20 in the aforementioned embodiment, the present invention can be applied to an e-mail having a file attached thereto. In this case, the controller 180 can receive the file attached to the e-mail with the header and body of the e-mail if the e-mail receiving mode is determined as the entire receiving mode. Furthermore, if the mobile terminal 100 operates in the entire receiving mode, the controller 180 can apply the entire receiving mode to the header and body of the e-mail and receive the attached file only when the user requests the mobile terminal 100 to receive the attached file through the user input unit 130. Moreover, when the mobile terminal 100 operates in the entire receiving mode, the controller 180 can apply the entire receiving mode to the header and body of the e-mail, receive the attached file with the header and body of the e-mail only when the size of the attached file is less than a predetermined size and receive the attached file only when the user requests the mobile terminal 100 to receive the attached file through the user input unit 130 if the file size is greater than the predetermined size.

As described above, the mobile terminal according to the embodiment of the present invention determines the best e-mail receiving mode in consideration of the e-mail receiving environment according to the characteristic of a network or the mobile terminal and the e-mail utilization pattern of the user. Accordingly, it is possible to minimize current consumed to receive e-mail while satisfying QoS (Quality of Service) of the e-mail service.

The above-described method of E-mail service providing method of the mobile terminal may be written as computer programs and may be implemented in digital microprocessors that execute the programs using a computer readable recording medium. The method of controlling the mobile terminal may be executed through software. The software may include code segments that perform required tasks. Programs or code segments may also be stored in a processor readable medium or may be transmitted according to a computer data signal combined with a carrier through a transmission medium or communication network.

The computer readable recording medium may be any data storage device that can store data that can be thereafter read by a computer system. Examples of the computer readable recording medium may include read-only memory (ROM), random-access memory (RAM), CD-ROMs, DVD±ROM, DVD-RAM, magnetic tapes, floppy disks, optical data storage devices. The computer readable recording medium may also be distributed over network coupled computer systems so that the computer readable code is stored and executed in a distribution fashion.

The foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art.

## Claims

1. A method of receiving e-mail by a mobile terminal, the method comprising:
determining one of a split receiving mode and an entire receiving mode as an e-mail receiving mode of the mobile terminal, said determination being based on either an e-mail receiving environment of the mobile terminal or an e-mail utilization pattern of a user of the mobile terminal; and
operating in the determined e-mail receiving mode to receive e-mail, wherein, in the split receiving mode, the mobile terminal receives parts of an e-mail transmitted from a sender and then receives the entire e-mail only when the user requests the mobile terminal to receive the entire e-mail and, in the entire receiving mode, the mobile terminal receives an entire e-mail transmitted from the sender at a time,
wherein the e-mail receiving environment is determined by the mobile terminal by analyzing a power consumption of the mobile terminal, the method being **characterized in that**:
the e-mail utilization pattern is determined by the mobile terminal by analyzing a ratio of entire e-mails that are requested by the user to received e-mails, and **in that** the step of analyzing the power consumption comprises analyzing a consumed current variation to receive e-mail according to e-mail size, in order to obtain a threshold value of an e-mail size at which consumed current begins to vary,
wherein the step of determining comprises determining the entire receiving mode as the e-mail receiving mode of the mobile terminal if the threshold value is greater than a calculated average e-mail size.

2. The method of claim 1, wherein the step of determining comprises determining the entire receiving mode as the e-mail receiving mode of the mobile terminal if the ratio of entire e-mails that are requested by the user to the received e-mails is higher than a predetermined value.

3. The method of claim 1, wherein the e-mail is received via an e-mail push function.

4. A mobile terminal configured to perform the method steps of any one of claims 1 to 3.

## Patentansprüche

1. Verfahren zum Empfangen von E-Mail durch ein mobiles Endgerät, wobei das Verfahren umfasst:
Bestimmen eines Teilempfangsmodus oder eines Gesamtempfangsmodus als E-Mail-Empfangsmodus des mobilen Endgeräts, wobei das Bestimmen entweder auf einer E-Mail-Empfangsumgebung des mobilen Endgeräts oder einem E-Mail-Nutzungsmuster eines Nutzers des mobilen Endgeräts basiert; und
Arbeiten in dem bestimmten E-Mail-Empfangsmodus, um E-Mail zu empfangen,
wobei das mobile Endgerät in dem Teilempfangsmodus einen Teil einer E-Mail, die von einem Sender übertragen wird, empfängt und dann die ganze E-Mail nur empfängt, wenn der Benutzer das mobile Endgerät auffordert, die ganze E-Mail zu empfangen, und das mobile Endgerät in dem Gesamtempfangsmodus jeweils eine ganze E-Mail, die von dem Sender übertragen wird, empfängt,
wobei die E-Mail-Empfangsumgebung durch das mobile Endgerät bestimmt wird durch Analysieren eines Energieverbrauchs des mobilen Endgeräts,
wobei das Verfahren **dadurch gekennzeichnet ist, dass**:
das E-Mail-Nutzungsmuster durch das mobile Endgerät bestimmt wird durch Analysieren eines Verhältnisses von ganzen E-Mails, die von dem Benutzer angefordert werden, zu empfangenen E-Mails,
und dass der Schritt des Analysierens des Energieverbrauchs ein Analysieren einer Schwankung verbrauchten Stroms, um E-Mail zu empfangen, entsprechend einer E-Mail-Größe umfasst, um einen Schwellenwert einer E-Mail-Größe zu erhalten, bei der verbrauchte Strom zu schwanken beginnt,
wobei der Schritt des Bestimmens ein Bestimmen des Gesamtempfangsmodus als E-Mail-Empfangsmodus des mobilen Endgeräts umfasst, wenn der Schwellenwert größer als eine berechnete Durchschnitts-E-Mail-Größe ist.

2. Verfahren nach Anspruch 1, wobei der Schritt des Bestimmens ein Bestimmen des Gesamtempfangsmodus als E-Mail-Empfangsmodus des mobilen Endgeräts umfasst, wenn das Verhältnis von ganzen E-Mails, die von dem Benutzer angefordert werden, zu empfangenen E-Mails größer als ein vorbestimmter Wert ist.

3. Verfahren nach Anspruch 1, wobei die E-Mail über eine E-Mail-Push-Funktion empfangen wird.

4. Mobiles Endgerät, das dazu eingerichtet ist, die Verfahrensschritte eines der Ansprüche 1 bis 3 auszuführen.

## Revendications

1. Procédé de réception de courrier électronique par un terminal mobile, le procédé comprenant les étapes consistant à :
déterminer l'un parmi un mode de réception divisé et un mode de réception entier en tant que mode de réception de courrier électronique du terminal mobile, ladite détermination étant basée soit sur un environnement de réception de courrier électronique du terminal mobile soit sur un modèle d'utilisation de courrier électronique d'un utilisateur du terminal mobile ; et
fonctionner dans le mode de réception de courrier électronique déterminé pour recevoir un courrier électronique,
dans lequel, dans le mode de réception divisé, le terminal mobile reçoit des parties d'un courrier électronique transmis depuis un expéditeur puis reçoit le courrier électronique entier uniquement lorsque l'utilisateur demande que le terminal mobile reçoive le courrier électronique entier et, dans le mode de réception entier, le terminal mobile reçoit un courrier électronique entier transmis depuis l'expéditeur en une fois,
dans lequel l'environnement de réception de courrier électronique est déterminé par le terminal mobile en analysant une consommation d'énergie du terminal mobile,
le procédé étant **caractérisé en ce que** :
le modèle d'utilisation de courrier électronique est déterminé par le terminal mobile en analysant un rapport des courriers électroniques entiers qui sont demandés par l'utilisateur par rapport aux courriers électroniques reçus,
et **en ce que** l'étape consistant à analyser la consommation d'énergie comprend l'analyse d'une variation de courant consommé pour recevoir un courrier électronique en fonction d'une taille de courrier électronique, afin d'obtenir une valeur de seuil d'une taille de courrier électronique à laquelle le courant consommé commence à varier,
dans lequel l'étape de détermination comprend la détermination du mode de réception entier en tant que mode de réception de courrier électronique du terminal mobile si la valeur de seuil est supérieure à une taille de courrier électronique moyenne calculée.

2. Procédé selon la revendication 1, dans lequel l'étape de détermination comprend la détermination du mode de réception entier en tant que mode de réception de courrier électronique du terminal mobile si le rapport des courriers électroniques entiers qui sont demandés par l'utilisateur par rapport aux courriers électroniques reçus est supérieur à une valeur prédéterminée.

3. Procédé selon la revendication 1, dans lequel le courrier électronique est reçu via une fonction push de courrier électronique.

4. Terminal mobile configuré pour exécuter les étapes de procédé selon l'une quelconque des revendications 1 à 3.
